# EUROPEAN PATENT APPLICATION

(11) **EP 2 139 075 A2**
(43) Date of publication of application: **30.12.2009**
(21) Application number: 09155259.6
(22) Date of filing: 16.03.2009
(51) Int. Cl.: H01R 12/34, H01R 12/36

(54) **Press-fit contact, connector, and connection structure of press-fit contact**

(30) Priority: 27.06.2008 JP 2008168953
(71) Applicant: Fujitsu Limited, Kawasaki-shi, Kanagawa 211-8588 (JP)
(72) Inventor: Kojima, Setsuo, Kanagawa 211-8588 (JP)
(74) Representative: Fenlon, Christine Lesley

(57) **Abstract**

A press-fit contact (2) to be press-fit into a hole (7) formed in a substrate (6) so as to be retained in and electrically connected to the substrate (6) includes a retention part (11) configured to be retained in the substrate (6) by being press-fit into the hole (7) and a contact part (12) configured to be electrically connected to the substrate (6), wherein the retention part (11) and the contact part (12) are separated and spaced apart from each other.

## Description

### FIELD

A certain aspect of the embodiments discussed herein is related to a press-fit contact, a connector, and the connection structure of the press-fit contact.

### BACKGROUND

In general, connectors are used in the back panels of computers, work stations, and switches. Recently, press-fit contacts have often been used as contacts in such connectors in view of dispensing with solder and improving the efficiency of operations. (See, for example, Patent Documents 1 and 2 listed below.) Connectors using press-fit contacts, which can be connected to a board or substrate by simply press-fitting the press-fit contacts into the board or substrate without using solder, can therefore obviate the need for solder and improve the efficiency of operations.

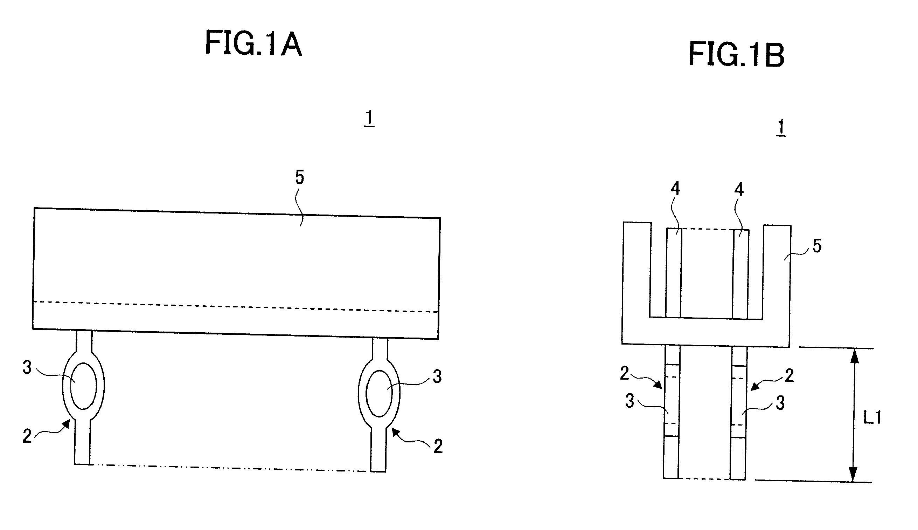

FIGS. 1A and 1B illustrate a press-fit connector (hereinafter simply referred to as "connector") 1 using press-fit contacts (hereinafter simply referred to as "contacts") 2 as a conventional example. The connector 1 includes the press-fit contacts 2 and a molded part 5.

Each contact 2 includes a contact and retention part 3 and a terminal part 4, and has a predetermined portion thereof fixed to the molded part 5. Usually, a large number of contacts 2 are arranged in a matrix in the molded part 5. For convenience of graphical representation, however, the contacts 2 are arranged in two rows and only the contact 2 at each end of each row is illustrated in FIGS. 1A and 1B.

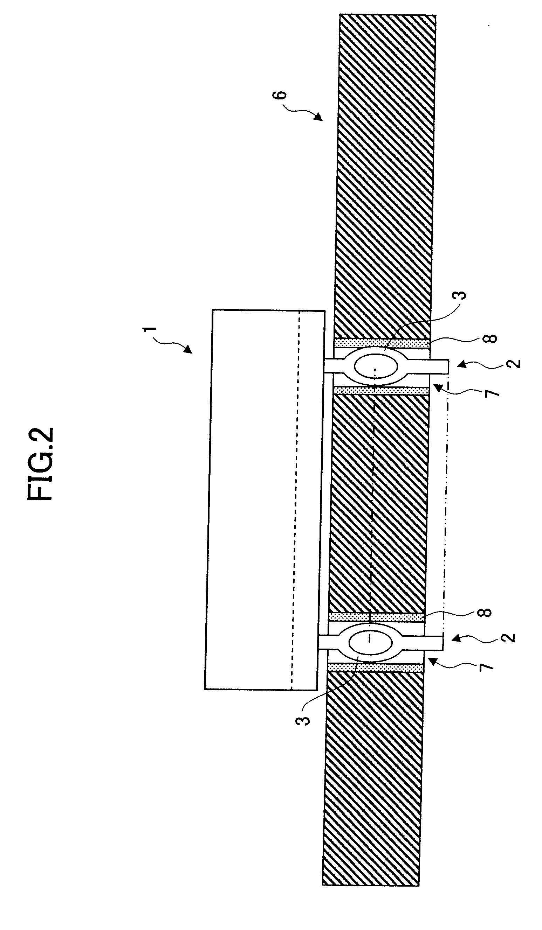

FIG. 2 illustrates the connector 1 connected to a printed circuit board 6. A large number of through holes 7 (of which only two are illustrated in FIG. 2 for convenience of graphical representation) are formed in the printed circuit board 6 at positions corresponding to the arrangement positions of the contacts 2 of the connector 1 connected to the printed circuit board 6. Each through hole 7 is internally plated with conductive metal so as to have a through hole electrode 8 formed inside.

In order to connect the connector 1 to the printed circuit board 6, the contacts 2 and through holes 7 are positioned relative to each other, and the contacts 2 are press-fit into the corresponding through holes 7. As a result, the contact and retention parts 3 of the contacts 2 are pressed against the inside of the corresponding through holes 7, so that the contacts 2 are (the connector 1 is) retained (held) in the printed circuit board 6. At the same time, the contact and retention parts 3 are electrically connected to the corresponding through hole electrodes 8, so that the connector 1 and the printed circuit board 6 are electrically connected. Thus, according to the conventional connector 1 and contacts 2, the contact and retention parts 3 serve to mechanically retain the contacts 2 (the connector 1) in the printed circuit board 6 and to electrically connect the contacts 2 (the connector 1) to the printed circuit board 6.
[Patent Document 1] Japanese Laid-Open Patent Publication No. 2000-260513
[Patent Document 2] Japanese Laid-Open Patent Publication No. 2005-294025

### SUMMARY

It is an object in one aspect of the invention to provide a press-fit contact, a connector, and the connection structure of the press-fit contact that are capable of reducing noise due to an antenna effect described below.

According to an aspect of the present invention, a press-fit contact to be press-fit into a hole formed in a substrate so as to be retained in and electrically connected to the substrate includes a retention part configured to be retained in the substrate by being press-fit into the hole and a contact part configured to be electrically connected to the substrate, wherein the retention part and the contact part are separated and spaced apart from each other.

According to an aspect of the present invention, a connection structure of a press-fit contact to be press-fit into a hole formed in a substrate so as to be retained in and electrically connected to the substrate is provided wherein the substrate has an insulation structure inside the hole and has an electrode formed on a surface of the substrate; the press-fit contact includes a retention part press-fit into the hole and a contact part electrically connected to the substrate, the retention part and the contact part being separated and spaced apart from each other; and the press-fit contact is electrically connected to the substrate by the contact part being in contact with the electrode with the retention part being press-fit into the hole.

The object and advantages of the embodiments will be realized and attained by means of the elements and combinations particularly pointed out in the claims.

It is to be understood that both the foregoing general description and the following detailed description are exemplary and explanatory and not restrictive of the invention, as claimed.

### BRIEF DESCRIPTION OF THE DRAWING(S)

FIGS. 1A and 1B are diagrams for illustrating a press-fit contact and a connector using the press-fit contact as a conventional example;
FIG. 2 is a diagram illustrating the connector connected to a printed circuit board;
FIGS. 3A and 3B are a front view and a side view, respectively, of a press-fit contact according to a first embodiment of the present invention;
FIGS. 4A and 4B are a partially cross-sectional front view and a partially cross-sectional side view, respectively, of a printed wiring board and the press-fit contact connected thereto according to the first embodiment of the present invention;
FIGS. 5A and 5B are a partially cross-sectional front view and a side view, respectively, of a connector and the printed wiring board according to the first embodiment of the present invention;
FIGS. 6A and 6B are a partially cross-sectional front view and a side view, respectively, of the printed wiring board and the connector connected thereto according to the first embodiment of the present invention;
FIG. 7 is a perspective view of a shelf having plug-in units attached thereto according to the first embodiment of the present invention;
FIG. 8 is a perspective view of the plug-in unit according to the first embodiment of the present invention;
FIG. 9 is a front view of a press-fit contact according to a second embodiment of the present invention;
FIG. 10 is a front view of a press-fit contact according to a third embodiment of the present invention; and
FIGS. 11A and 11B are a side view and a bottom view, respectively, of a press-fit contact according to a fourth embodiment of the present invention.

### DESCRIPTION OF EMBODIMENT(S)

As described above, according to the conventional press-fit connector 1 and press-fit contacts 2, the contact and retention parts 3 serve to mechanically retain the contacts 2 (the connector 1) in the printed circuit board 6 and to electrically connect the contacts 2 (the connector 1) to the printed circuit board 6. This inevitably causes the contact and retention parts 3 to be large in length.

That is, in the case of considering only retaining the contacts 2 (the connector 1) mechanically in the printed circuit board 6, the contact and retention parts 3 may be relatively short for the purpose of biting the corresponding through holes 7. However, in order to ensure the electrical connection of the contacts 2 to the printed circuit board 6, it is desirable to make the contact area of the contact and retention parts 3 and the corresponding through hole electrodes 8 as large as possible.

Therefore, conventionally, the length L1 (indicated by a double-headed arrow in FIG. 1B) of the contact and retention parts 3 is relatively large (for example, more than or equal to 2.5 mm). Further, an increase in the length of the contact and retention parts 3 results in an increase in the length of the through hole electrodes 8.

However, the contact and retention parts 3 and the through hole electrodes 8 thus elongated may serve as an antenna to receive external electromagnetic waves and introduce radio noise into a system. Further, the elongated contact and retention parts 3 and through hole electrodes 8 may also emit to the outside radio waves generated inside another electronic device provided on the printed circuit board 6 connected to the connector 1. These effects may be referred to as "an antenna effect."

Preferred embodiments of the present invention are explained below with reference to the accompanying drawings.

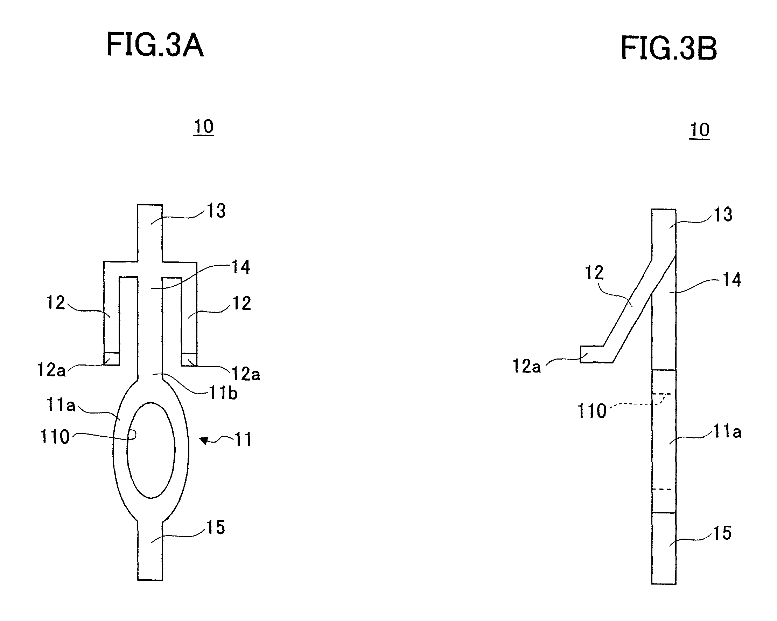

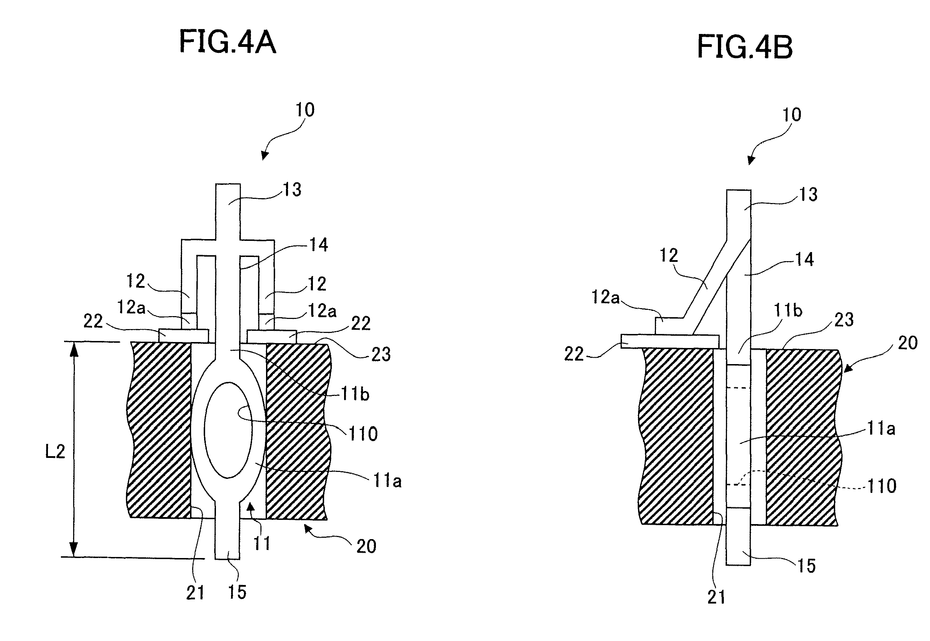

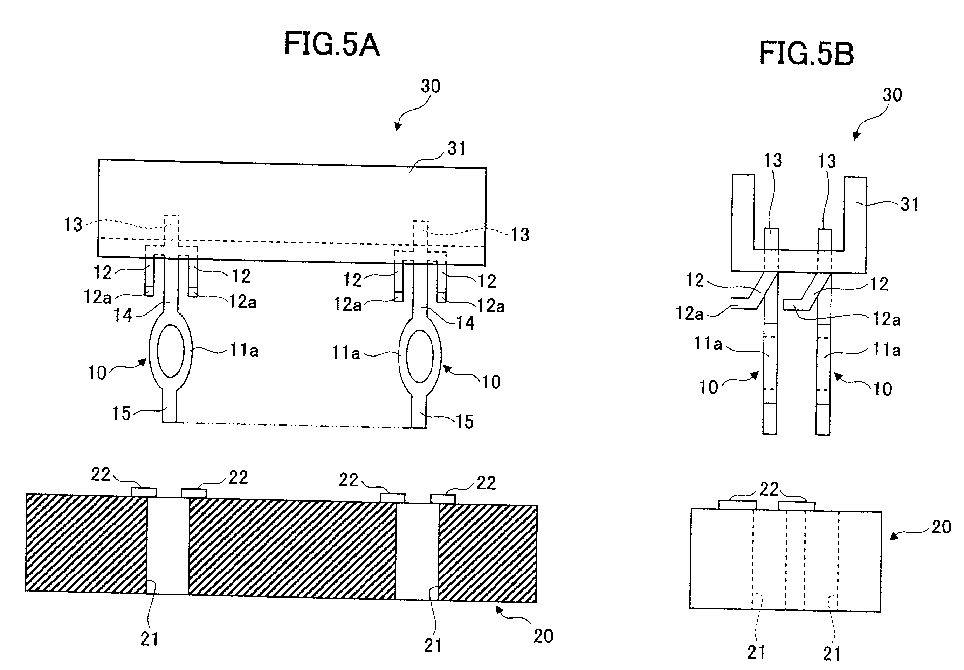

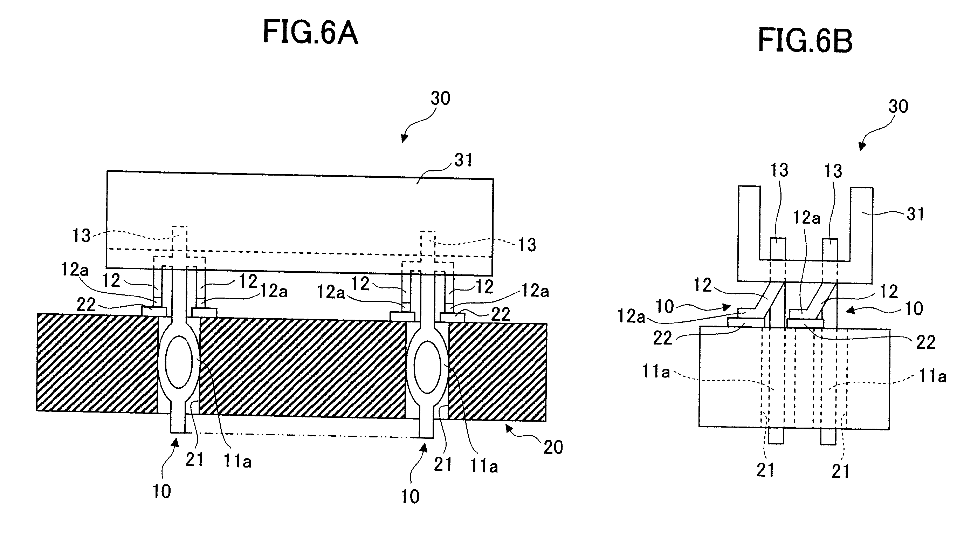

FIGS. 3A and 3B, FIGS. 4A and 4B, FIGS. 5A and 5B, and FIGS. 6A and 6B are diagrams for illustrating a press-fit contact (hereinafter simply referred to as "contact") 10 and a connector 30 of a press-fit type to which multiple press-fit contacts 10 are applied according to a first embodiment of the present invention. FIGS. 3A and 3B illustrate the contact 10. FIGS. 4A and 4B illustrates the contact 10 connected to a printed wiring board 20. FIGS. 5A and 5B illustrate the connector 30 using the contacts 10. FIGS. 6A and 6B illustrates the connector 30 connected to the printed wiring board 20.

Referring to, for example, FIGS. 3A and 3B, the contact 10 includes a retention part 11, a pair of contact parts 12, a terminal part 13, and a connecting part 14. As illustrated in FIGS. 4A and 4B, the contact 10 is press-fit into a corresponding through hole 21 formed in a board or substrate (the printed wiring board 20 in this embodiment), and is thereby retained (held) in and electrically connected to the printed wiring board 20. The contact 10 is formed by performing press working on a plate material with a spring characteristic of a connector material such as a high-strength spring material or a medium-strength spring material. Examples of the high-strength material include Cu-Be, Cu-Ti, and Cu-Ni-Sn. The medium-strength spring material is principally phosphor bronze, but may also be Cu-Ni-Si or Cu-low Sn. Therefore, the contact 10 has the retention part 11, the contact parts 12, the terminal part 13, and the connecting part 14 formed as a unit (unitary structure).

As described below, the retention part 11 is press-fit into the through hole 21 formed in the printed wiring board 20 (as illustrated in FIG. 4A). The retention part 11 is press-fit into the through hole 21, so that the contact 10 is retained (held) in the printed wiring board 20.

The retention part 11 includes an elliptic annular part 11a having an elliptic opening 110 inside. The elliptic annular part 11a has an elliptic shape when viewed from its front side (as illustrated in FIG. 3A). Therefore, the retention part 11, formed by shaping a spring material, is elastically deformable in the shortest-diameter (minor-axis) directions of the elliptic annular part 11a (in the lateral [right-left] directions in FIG. 3A). The dimension of the retention part 11 along the minor axis of the elliptic annular part 11a, or the width of the retention part 11, is slightly greater than the diameter of the through hole 21 formed in the printed wiring board 20.

The retention part 11 includes an upper end part 11b formed in an upper end portion thereof and a lower end part 15 formed in a lower end portion thereof. The upper end part 11b projects (extends) upward from the elliptic annular part 11a. The lower end part 15 projects (extends) downward from the elliptic annular part 11a. The lower end part 15 can be used to position the contact 10 at the time of press-fitting the contact 10 into the through hole 21 of the printed wiring board 20.

Further, the connecting part 14 is formed at the upper end of the retention part 11. The connecting part 14 is formed to extend upward from the upper end part 11b of the retention part 11. Further, the contact parts 12 are formed on the connecting part 14 at corresponding positions spaced apart from the retention part 11.

According to this embodiment, the contact parts 12 are formed on the opposite sides of the connecting part 14 so that the connecting part 14 is positioned therebetween. Further, as illustrated in FIG. 3B, the contact parts 12 are formed to extend obliquely downward to the front side from the connecting part 14. Accordingly, each of the contact parts 12 has a cantilever configuration so as to have a spring characteristic.

Further, each of the contact parts 12 has a lower end part thereof bent horizontally (in a direction away from the connecting part 14) to form a contact point 12a to be electrically connected to a corresponding electrode pad 22 (for example, FIGS. 4A and 4B) of the printed wiring board 20. Further, the contact points 12a are positioned higher than the upper end of the retention part 11 (when the contact 10 is in an upright position as illustrated in, for example, FIGS. 3A and 3B). That is, the distance between the contact points 12a and a plane including the lower end of the retention part 11 is greater than a length L2 (indicated by a double-headed arrow in FIG. 4A) of the retention part 11 (the distance between the upper end and the lower end of the retention part 11. Thus, the contact 10 according to this embodiment has the retention part 11 and the contact parts 12 separated from each other. As described below, the positions of the contact points 12a and the position of the retention part 11 may be determined based on the thickness of the printed wiring board 20 to be connected to the contact 10.

According to this embodiment, the two contact parts 12 are formed so that the connecting part 14 is positioned therebetween. However, the number of contact parts 12 is not limited to two.

The terminal part 13 is formed at the upper end of the connecting part 14. The terminal part 13 connects to another electronic component. Specifically, for example, the terminal part 13 connects to a contactor of another connector. As a result, another electronic component (for example, another connector) electrically connects to the printed wiring board 20 through the contact 10.

Next, a description is given of a connection structure connecting the contact 10 having the above-described configuration to the printed wiring board 20.

According to this embodiment, the printed wiring board 20 is used as a board or substrate. However, the present invention is applicable to not only the printed wiring board 20 but also a wide range of boards or substrates such as ceramic substrates, silicon substrates, multilayer substrates, and single-layer substrates.

Referring to FIGS. 4A and 4B, the through hole 21 is formed where the contact 10 is to be connected in the printed wiring board 20. As described above, the diameter of the through hole 21 is less than the width of the retention part 11. Further, according to this embodiment, no through hole electrode is formed on the inner wall of the through hole 21, so that the inner wall of the through hole 21 is insulated.

Further, the electrode pads 22 are formed on the surface of the printed wiring board 20 on the side from which the contact 10 is to be press-fit into the corresponding through hole 21. The electrode pads 22 are arranged (positioned) so as to correspond to the positions of the contact parts 12, specifically, the contact points 12a, of the contact 10.

In connecting the contact 10 to the printed wiring board 20, first, the lower end part 15 of the retention part 11 is positioned relative to the corresponding through hole 21 and inserted into the corresponding through hole 21. Since the diameter of the through hole 21 is less than the width of the retention part 11, the retention part 11 first engages with the upper circumferential edge of the through hole 21 of the printed wiring board 20.

Pressing the contact 10 further into the through hole 21 from the above-described position causes the retention part 11 to be press-fit into the through hole 21 while deforming elastically. At this point, since no through hole electrode is formed in the through hole 21, the retention part 11 and the printed wiring board 20 are prevented from being electrically connected. According to this embodiment, the retention part 11 is press-fit into the through hole 21 to be mechanically held in but not electrically connected to the printed wiring board 20.

On the other hand, when the contact 10 is press-fit into the through hole 21 up to an attachment position, the contact points 12a formed in the lower end parts of the contact parts 12 are pressed against (in pressure contact with) the corresponding electrode pads 22 formed on the printed wiring board 20. As described above, the contact parts 12 have a cantilever shape and accordingly have a spring characteristic. Further, the depth (amount) of insertion of the contact 10 into the through hole 21 is determined so that the contact points 12a are pressed with an elastic force against the corresponding electrode pads 22.

That is, the depth of insertion of the contact 10 is determined so as to be greater by a predetermined amount than the depth at the time of the contact points 12a coming into contact with the corresponding electrode pads 22. This predetermined amount is such as to enable the contact parts 12 to apply to the corresponding electrodes 22 a pressure contact force (an elastic force) that optimizes the electrical connection between the contact parts 12 and the corresponding electrode pads 22.

Thus, according to the contact 10 and its connection structure of this embodiment, the retention part 11 is press-fit into the corresponding through hole 21 and the contact 10 is thereby held in the printed wiring board 20. Further, the contact parts 12 are pressed against the corresponding electrode pads 22 and the contact 10 and the printed wiring board 20 are thereby electrically connected. Thus, according to this embodiment, the retention part 11 and the contact parts 12 are separated and spaced apart from each other, and are provided with different functions (a mechanical retention function and an electrical connection function, respectively).

As a result, it is not necessary for the length L2 (FIG. 4A) of the retention part 11 to take electrical connection into consideration, so that the length L2 of the retention part 11 can be a minimum sufficient value to retain the contact 10 in the printed wiring board 20. For example, the length L2 is 1 mm. Accordingly, the length L2 of the retention part 11 can be less than the length L1 (FIG. 1B) of the corresponding portion of the conventional contact 2. According to this embodiment, since the retention part 11 can be reduced in length, it is possible to reduce the possibility of the retention part 11 serving as an antenna to receive external electromagnetic waves.

Further, a through hole electrode such as the through hole electrode 8 of FIG. 2, which may also serve as an antenna, is not formed in the through hole 21 in the connection structure according to this embodiment. Accordingly, the retention part 11 and the through hole 21 are prevented from serving as an antenna to receive external electromagnetic waves, so that it is possible to prevent radio noise from being mixed into the signals exchanged between the contact parts 12 and the corresponding electrode pads 22.

FIGS. 5A and 5B and FIGS. 6A and 6B illustrate the contacts 10 having the above-described configuration, and the connector 30 using the contacts 10. The connector 30 includes the contacts 10 and a molded part 31, which may serve as a plug body.

The molded part 31 is formed of insulating resin. The molded part 31 is formed by insert molding with a portion of the connecting part 14 of each contact 10 being inserted in the molded part 31, so that the contacts 10 are fixed to the molded part 31. Further, the contacts 10 are arranged in a matrix (multiple rows and columns) in the molded part 31. Further, the terminal parts 13 protrude inside the molded part 31. According to this embodiment, by way of example, the contacts 10 are arranged in two rows in the molded part 31, and the contact 10 at each end of each row is graphically illustrated in FIGS. 5A and 5B and FIGS. 6A and 6B.

On the other hand, in the printed wiring board 20 to which the connector 30 configured as described above connects, the through holes 21 are formed at positions corresponding to the positions where the contacts 10 are arranged. Further, the electrode pads 22 are formed at positions corresponding to the contact parts 12 (contact points 12a) on the surface of the printed wiring board 20. Further, as described above with reference to FIGS. 4A and 4B, no through hole electrode is formed in the through holes 21. Accordingly, the through holes 21 have an insulative (electrically non-conductive) inner wall.

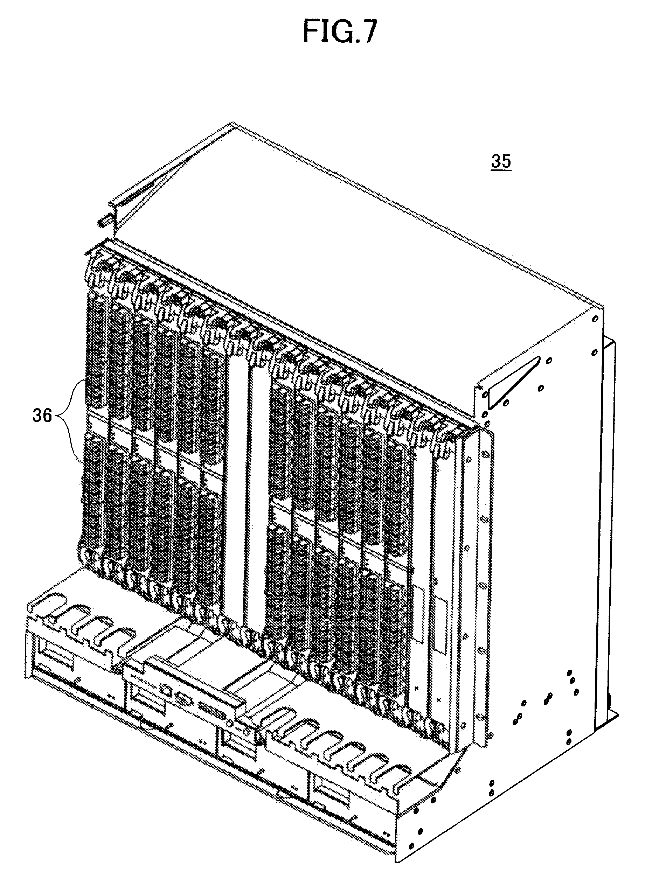

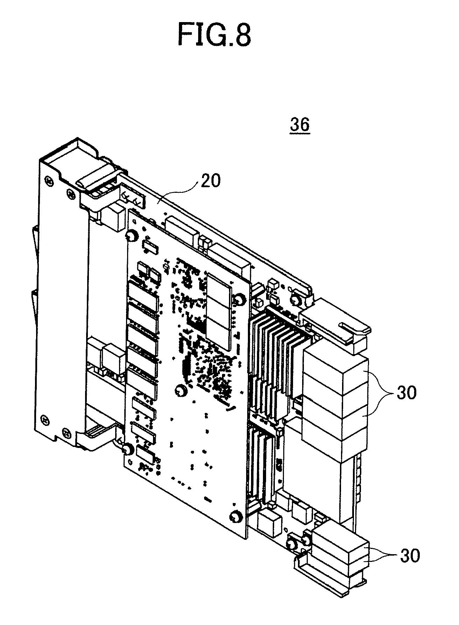

The printed wiring board 20 and the connector 30 configured as described above are applied to, for example, plug-in units (PIUs) 36 attached to a shelf 35 of a communications device as illustrated in FIG. 7. That is, as illustrated in an enlarged view in FIG. 8, each PIU 36 has multiple electronic components and electronic devices mounted on the printed wiring board 20. In order to connect the PIU 36 to the shelf 35, multiple connectors 30 are provided on an edge part of the printed wiring board 20. The connection structure of connecting the contact(s) 10 to the printed wiring board 20 according to this embodiment is applied in providing the connector 30 on the printed wiring board 20.

In connecting the connector 30 to the printed wiring board 20, the contacts 10 are positioned relative to the corresponding through holes 21 while the molded part 31 is being held, and the retention part 11 of each contact 10 is press-fit into the corresponding through hole 21 up to a position where the contact parts 12 of the contact 10 are pressed against the corresponding electrode pads 22 with a predetermined spring force. Since the retention part 11 of the contact 10 can be reduced in length (to the length L2) as described above according to this embodiment, the amount of press-fitting can be reduced by the reduction in length in connecting the connector 30 to the printed wiring board 20, so that it is possible to improve operability.

Referring back to FIGS. 6A and 6B, which illustrate the connector 30 connected to the printed wiring board 20, the connector 30 having the multiple contacts 10 is connected to the printed wiring board 20. In such a case, the signals exchanged (transmitted or received) between the connector 30 and the printed wiring board 20 would be greatly affected if the retention part 11 of one or more of the contacts 10 served as an antenna. According to the connection structure of this embodiment, however, the retention part 11 of each contact 10 is prevented from serving as an antenna. Accordingly, it is possible to prevent noise from being included in signals, so that the contact 10 can have increased reliability.

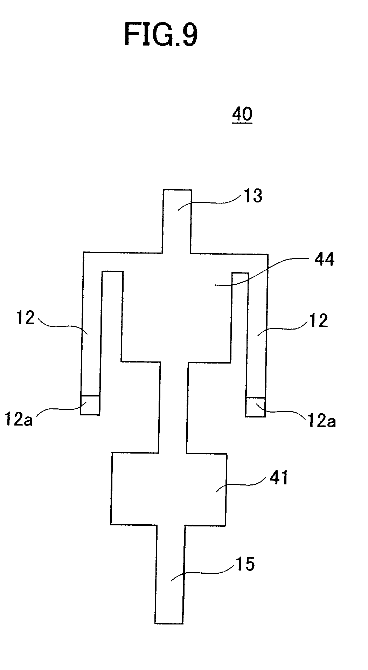

Next, a description is given, with reference to FIG. 9, FIG. 10, and FIGS. 11A and 11B, of press-fit contacts 40, 50, and 60 according to a second embodiment, a third embodiment, and a fourth embodiment, respectively, of the present invention. In FIGS. 9 through 11B, elements or configurations corresponding to those illustrated in FIGS. 3A through 6B are referred to by the same reference numerals, and a description thereof is suitably omitted.

FIG. 9 illustrates the contact 40 according to the second embodiment of the present invention. In the contact 10 described with reference to, for example, FIGS. 3A through 4B according to the first embodiment, the retention part 11 is provided with elasticity by forming the elliptic opening 110 therein, and the connecting part 14 is narrow (reduced in width). On the other hand, according to the second embodiment, the contact 40 includes a retention part 41 with no opening and a connecting part 44 wider than the connecting part 14 of the first embodiment.

Since the retention part 41 has no opening, the retention part 41 has high rigidity. Therefore, in press-fitting the retention part 41 into the corresponding through hole 21 of the printed wiring board 20, the retention part 41 can be press-fit in such a manner as to bite the printed wiring board 20. This ensures retention of the contact 40 in the printed wiring board 20.

Further, since the connecting part 44 has a large width, it is possible to increase the strength of coupling of the molded part 31 and the contact 40 by molding the molded part 31 with the connecting part 44 inserted therein. Accordingly, even in press-fit contacting that press-fits the retention part 41 into the corresponding through hole 21 of the printed wiring board 20, it is possible to prevent occurrence of loosening or cracks due to insufficient coupling strength between the molded part 31 and the contact 40.

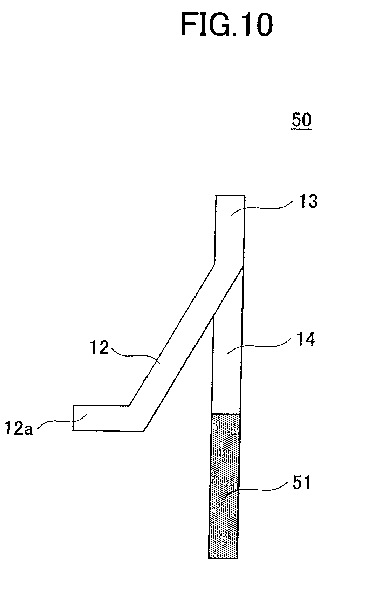

FIG. 10 illustrates the contact 50 according to the third embodiment of the present invention. The contact 50 according to this embodiment includes an insulated retention part 51, which is formed by forming a film of an insulating material on a portion corresponding to the retention part 11 of the first embodiment. The insulated retention part 51 thus has an insulation characteristic.

In the case of assuming the printed wiring board 20 to be a multilayer printed wiring board, an interlayer interconnect may be exposed inside the through hole 21. Accordingly, if the interlayer interconnect exposed inside the through hole 21 and the retention part are electrically connected, noise may be included in a signal.

However, by coating a portion of the connector 30 to be pressed against the inner wall of the through hole 21 with an insulating material to form the insulated retention part 51 as in this embodiment, it is possible to prevent the insulated retention part 51 and an interlayer interconnect of the printed wiring board 20 from being electrically connected even if the printed wiring board 20 is a multilayer printed wiring board. Accordingly, it is possible to further increase the reliability of the connection between the contact and the printed wiring board 20 by using the contact 50 according to this embodiment.

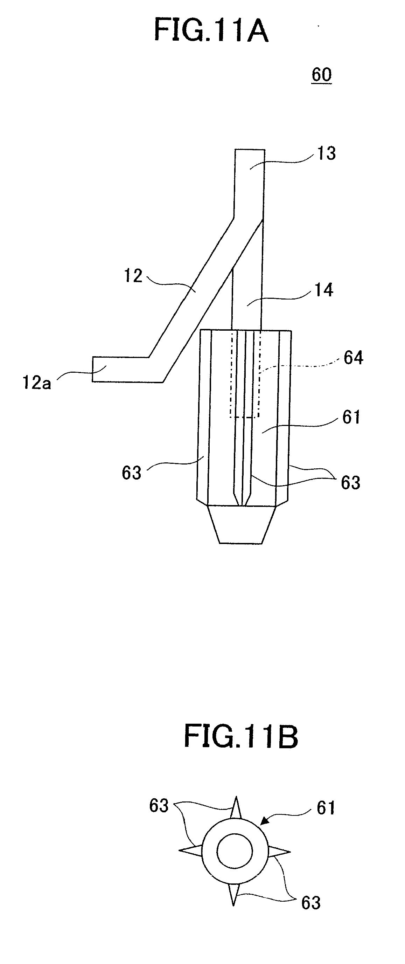

FIGS. 11A and 11B illustrate the contact 60 according to the fourth embodiment of the present invention. The contact 10 according to the above-described first embodiment has the retention part 11 and the contact parts 12 formed as a unit by performing press working on a plate material having a spring characteristic.

On the other hand, according to the contact 60 of this embodiment, the contact parts 12 and a retention part 61 are formed of different materials. Specifically, according to this embodiment, the contact parts 12, the connecting part 14, and the terminal part 13 are formed as a unit (unitary structure) by performing press working on a plate material having a spring characteristic, and the retention part 61 is formed of an insulating resin. (Hereinafter, the retention part 61 formed of resin is referred to as "resin-made retention part 61").

The connecting part 14 has a predetermined portion of its lower end part fixed to the resin-made retention part 61 by insert molding. The portion of the connection part 14 inserted into the resin-made retention part 61 by insert molding is referred to as an insert part 64. As a result, the connecting part 14 and the resin-made retention part 61 are integrated.

Further, multiple projection parts 63 projecting outward are formed on the peripheral surface of the resin-made retention part 61. When the contact 60 is press-fit into the through hole 21 of the printed wiring board 20, these projection parts 63 are pressed against or bite the inner wall of the through hole 21, so that the contact 60 is held in the printed wiring board 20. Examples of the material of the resin-made retention part 61 include an insulating resin such as polypropylene.

According to this embodiment, the resin-made retention part 61 is formed of an insulating resin. Therefore, it is possible to ensure preventing the resin-made retention part 61 from serving as an antenna. Further, since the multiple projection parts 63 can be formed on the resin-made retention part 61, it is possible to ensure retention of the resin-made retention part 61 in the printed wiring board 20.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority or inferiority of the invention. Although the embodiments of the present inventions have been described in detail, it should be understood that various changes, substitutions, and alterations could be made hereto without departing from the spirit and scope of the invention.

For example, the through hole 21 having a circular cross-sectional shape is illustrated in the above-described embodiments. Alternatively, however, the through hole 21 may have a rectangular cross-sectional shape. Further, the through hole 21 may be replaced with a bottomed hole.

Further, the paired contact parts 12 extend in the same direction in the above-described embodiments. Alternatively, however, the contact parts 12 may extend in different or opposite directions. For example, one of the contact parts 12 may be formed to extend to the left side of the retention part 11 as illustrated in FIG. 3B, and the other one of the contact parts 12 may be formed to extend to the right side of the retention part 11 in FIG. 3B.

According to one aspect of the present invention, a contact part and a retention part can be determined in accordance with their respective functions. This makes it possible to reduce the retention part in length, so that it is possible to reduce the antenna effect.

## Claims

1. A press-fit contact to be press-fit into a hole formed in a substrate so as to be retained in and electrically connected to the substrate, the press-fit contact **characterized by**:
a retention part configured to be retained in the substrate by being press-fit into the hole; and
a contact part configured to be electrically connected to the substrate,
wherein the retention part and the contact part are separated and spaced apart from each other.

2. The press-fit contact as claimed in claim 1, **characterized in that** the contact part is configured to be electrically connected to the substrate on a surface thereof.

3. The press-fit contact as claimed in claim 1 or 2, **characterized in that** the contact part has a spring characteristic.

4. The press-fit contact as claimed in any of claims 1 to 3, **characterized in that** the retention part is coated with an insulating material.

5. The press-fit contact as claimed in any of claims 1 to 3, **characterized in that** the retention part is formed of an insulating resin.

6. A connector, **characterized by**:
the press-fit contact as set forth in any of claims 1 to 5; and
a plug body configured to hold the press-fit contact.

7. A connection structure of a press-fit contact to be press-fit into a hole formed in a substrate so as to be retained in and electrically connected to the substrate, **characterized in that**:
the substrate has an insulation structure inside the hole and has an electrode formed on a surface of the substrate;
the press-fit contact includes a retention part press-fit into the hole and a contact part electrically connected to the substrate, the retention part and the contact part being separated and spaced apart from each other; and
the press-fit contact is electrically connected to the substrate by the contact part being in contact with the electrode with the retention part being press-fit into the hole.

8. The connection structure of the press-fit contact as claimed in claim 7, **characterized in that** the contact part has a spring characteristic.

9. The connection structure of the press-fit contact as claimed in claim 7 or 8,
**characterized in that** the retention part is coated with an insulating material.

10. The connection structure of the press-fit contact as claimed in any of claims 7 to 9, **characterized in that** the retention part is formed of an insulating resin.
